# FASCICULE DE BREVET EUROPEEN

(11) **EP 4 675 245 B1**
(45) Date de publication et mention de la délivrance du brevet: **02.12.2026**
(21) Numéro de dépôt: 25186230.6
(22) Date de dépôt: 30.06.2025
(51) Int. Cl.: G01K 7/01, H10D 8/60, H10D 30/47, H10D 62/824, H10D 62/85, H10D 64/23, H10D 84/01, H10D 84/05, H10D 84/80

(54) **DISPOSITIF MICROÉLECTRONIQUE DE PUISSANCE**
MIKROELEKTRONISCHE LEISTUNGSVORRICHTUNG
MICROELECTRONIC POWER DEVICE

(30) Priorité: 03.07.2024 FR 2407274
(43) Date de publication de la demande: 07.01.2026
(73) Titulaire: Commissariat à l'Energie Atomique et aux Energies Alternatives, 75015 Paris (FR)
(72) Inventeur: ESCOFFIER, René, 38054 Grenoble cedex 09 (FR)
(74) Mandataire: Hautier IP

(56) Documents cités:
- US-A1- 2015 270 254
- US-A1- 2020 144 970

## Description

### DOMAINE TECHNIQUE

La présente invention concerne le domaine de la microélectronique. Elle trouve pour application particulièrement avantageuse la mesure de température pour des composants de puissance, typiquement pour des transistors de type HEMT (acronyme de « High Electron Mobility Transistor ») à base de GaN.

### ETAT DE LA TECHNIQUE

Les composants de puissance sont conçus pour fonctionner avec de fortes densités de courant et/ou avec des tensions de fonctionnement élevées. Le fonctionnement de ces composants génère un échauffement important, avec une température de fonctionnement qui peut atteindre 150°C. Un enjeu lié à la conception de ces composants de puissance concerne l'efficacité de dissipation thermique. Un autre enjeu concerne le contrôle de la température de fonctionnement de ces composants.

Pour répondre à ces enjeux, il est nécessaire de connaitre la température de ces composants en fonctionnement. Plusieurs méthodes ont été développées pour mesurer ou estimer la température de ces composants. Une méthode de mesure directe consiste à placer un capteur de température, par exemple un serpentin de métal, à proximité du composant à caractériser. En injectant un courant constant dans le serpentin et en mesurant la tension à ses bornes, on obtient une mesure directe de la température. Pour les transistors HEMT, le serpentin métallique peut être remplacé par un barreau conducteur placé au-dessus du gaz bidimensionnel d'électrons (2DEG) circulant dans les HEMT. Le document « Linear Temperature Sensors in High-Voltage GaN-HEMT Power Devices, R. Reiner et al., 2016 IEEE Applied Power Electronics Conference and Exposition (APEC) » divulgue un tel capteur de température intégré au sein d'une architecture de transistors HEMT. Cette solution augmente cependant l'encombrement du dispositif à base de transistors HEMT. Les barreaux conducteurs du capteur de température sont en outre disposés entre deux transistors HEMT. La température est donc mesurée à côté des transistors. Ce capteur ne mesure pas précisément la température de fonctionnement réelle au sein du transistor.

Pour d'autres types de composants, en particulier pour des transistors MOS (acronyme de « Metal Oxyde Semiconductor »), il est possible de tirer parti de la structure de ces transistors MOS pour mesurer une caractéristique de diode structurellement présente au sein des transistors MOS. Cette diode dite « diode body » est typiquement formée par une jonction PN entre les caissons du transistor. Une mesure de tension aux bornes de cette diode body permet d'accéder de façon indirecte à la température de fonctionnement du transistor. La température est ici mesurée au sein du transistor. Cette méthode, qui exploite une structure particulière du composant, n'est pas applicable à tous les composants. Les transistors HEMT en particulier ne peuvent pas être caractérisés via cette méthode. US 2020/144970 A1 montre une couche métallique résistive formée à la surface d'un circuit intégré dans lequel un ou plusieurs HEMTs sont formés. La couche métallique est une grille flottante, qui est isolée électriquement du vrai contact de grille au moyen d'une couche isolante.

Un objet de la présente invention est de proposer une architecture de capteur de température pour un composant de puissance surmontant les inconvénients mentionnés ci-dessus.

En particulier, un objet de la présente invention est de proposer un dispositif microélectronique de puissance comprenant des transistors HEMT et un capteur de température présentant un encombrement réduit.

Un autre objet de la présente invention est de proposer un dispositif microélectronique de puissance comprenant des transistors HEMT et un capteur de température présentant une précision de mesure améliorée.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un dispositif microélectronique de puissance comprenant :
- Une pluralité de transistors élémentaires à haute mobilité d'électrons formés sur une couche active et connectés en parallèle, chaque transistor élémentaire comprenant un doigt de source, un doigt de drain et un doigt de grille interposé entre le doigt de source et le doigt de drain,
- Un contact de source commun aux doigts de source,
- Un contact de drain commun aux doigts de drain,
- Un contact de grille commun aux doigts de grille.

Avantageusement, au moins un doigt de grille n'est pas connecté au contact de grille et forme un contact Schottky avec la couche active. Avantageusement ledit au moins un doigt de grille forme avec le doigt de drain voisin au moins une diode de type Schottky configurée pour mesurer une température de fonctionnement au sein du dispositif microélectronique de puissance.

Le dispositif microélectronique présente ainsi un capteur de température intégré dans la pluralité de transistors élémentaires, sous forme de diode Schottky. Ce capteur exploite au moins un doigt de grille et un doigt de drain d'un transistor élémentaire, qui sont des éléments existants du dispositif microélectronique de puissance. L'intégration du capteur dans le dispositif microélectronique de puissance est totale. L'encombrement du capteur dans le dispositif microélectronique de puissance est très limité, voire négligeable.

Par ailleurs, en exploitant le design existant d'un transistor élémentaire, la diode Schottky présente des caractéristiques de tenue en tension égales à celle du transistor élémentaire à partir duquel elle est formée. La température mesurée par la diode Schottky est très proche, voire égale à la température de fonctionnement réelle d'un transistor élémentaire du dispositif microélectronique de puissance. La précision de mesure du capteur vis-à-vis de la température de fonctionnement réelle des transistors élémentaires est améliorée.

Un principe de l'invention est de mesurer localement une température de fonctionnement par une diode Schottky en remplaçant un doigt de grille existant d'un dispositif microélectronique de puissance par un contact Schottky. Selon une possibilité, plusieurs doigts de grille peuvent être remplacés par des contacts Schottky, de sorte à former plusieurs diodes Schottky au sein du dispositif microélectronique de puissance. Il est ainsi possible d'accéder à plusieurs mesures de température localisées. Une cartographie de température de fonctionnement du dispositif microélectronique de puissance peut avantageusement être réalisée par le capteur selon l'invention. Cela permet de déceler d'éventuels points chauds lors du fonctionnement du dispositif microélectronique de puissance. Cela permet de prévenir ou d'éviter des défaillances du dispositif microélectronique de puissance.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1A, 1B illustrent schématiquement, respectivement en vue de dessus et en coupe transverse, un dispositif microélectronique de puissance comprenant des transistors HEMT, selon l'art antérieur.
Les figures 2A, 2B illustrent schématiquement, respectivement en vue de dessus et en coupe transverse, un dispositif microélectronique de puissance comprenant des transistors HEMT et un capteur de température, selon un mode de réalisation de la présente invention.
La figure 3 illustre schématiquement, en vue de dessus, une matrice de transistors HEMT d'un dispositif microélectronique de puissance, au sein de laquelle sont distribués des capteurs de température selon un mode de réalisation de la présente invention.
La figure 4A illustre schématiquement un capteur de température sous forme de diode Schottky intégrée aux transistors HEMT d'un dispositif microélectronique de puissance, selon un mode de réalisation de la présente invention.
La figure 4B illustre schématiquement un capteur de température sous forme de diode Schottky intégrée aux transistors HEMT d'un dispositif microélectronique de puissance, selon un autre mode de réalisation de la présente invention.
La figure 5 illustre schématiquement, en vue de dessus, un dispositif microélectronique de puissance comprenant une matrice de transistors HEMT et un capteur de température intégré, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches, et les dimensions des différents éléments (doigts, contacts etc) ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, l'au moins un doigt de grille formant le contact Schottky est connecté au doigt de source voisin. Cela permet de conserver uniquement une diode Schottky entre ledit doigt de grille et le doigt de drain voisin. Cela permet d'éviter de former une autre diode entre ledit doigt de grille et le doigt de source voisin.

Selon un exemple, ce doigt de source voisin est connecté au contact de source du dispositif microélectronique de puissance, de sorte que la mesure de la température de fonctionnement se fait par l'intermédiaire dudit contact de source. La mesure se fait typiquement en situation de blocage des transistors élémentaires, dans le troisième quadrant de la caractéristique de ces transistors élémentaires.

Selon un autre exemple, le dispositif microélectronique de puissance comprend au moins un contact de détection indépendant des contacts de source, drain et grille, et le doigt de source voisin, c'est-à-dire le doigt de source connecté à l'au moins un doigt de grille formant le contact Schottky, est connecté audit au moins un contact de détection, de sorte que la mesure de la température de fonctionnement se fait par l'intermédiaire dudit au moins un contact de détection. La mesure se fait indépendamment du fonctionnement des transistors élémentaires.

Selon un exemple, le dispositif comprend en outre une couche barrière, par exemple à base d'AlGaN, intercalée entre la couche active et les doigts de grille. Selon un exemple, l'au moins un doigt de grille formant le contact Schottky traverse au moins en partie ladite couche barrière. Selon un exemple alternatif, l'au moins un doigt de grille formant le contact Schottky est disposé sur ladite couche barrière. Le contact Schottky peut être réalisé par gravure de la couche barrière à base d'AlGaN, puis gravure de quelques nanomètres de la couche active à base de GaN, et par dépôt d'un métal, par exemple au moins 60 nanomètres de TiN ou quelques centaines de nanomètres de Nickel. Cela permet de contacter le 2DEG latéralement. Les métaux sont choisis en fonction de leur travail de sortie afin d'ajuster la barrière Schottky selon les besoins.

Selon un exemple, l'au moins un doigt de grille formant le contact Schottky comprend une pluralité de doigts de grille formant avec les doigts de drain voisins respectifs une pluralité de diodes de type Schottky configurées pour mesurer chacune une température de fonctionnement au sein du dispositif microélectronique de puissance. Cela permet de relever des températures dans différentes zones du dispositif. Si les anodes des diodes Schottky sont toutes connectées au contact de source, une mesure de température moyenne est obtenue. Si les anodes des diodes Schottky sont connectées à des contacts indépendants, des mesures locales de température sont obtenues.

Selon un exemple, le dispositif microélectronique de puissance comprend une pluralité de contacts de détection indépendants, et les doigts de grille de la pluralité de diodes Schottky sont connectés auxdits contacts de détection indépendants, de sorte que les températures de fonctionnement sont mesurées par l'intermédiaire desdits contacts de détection. Cela permet d'effectuer des mesures locales de température, par exemple sur plusieurs zones du dispositif.

Selon un exemple, un seul contact de détection de la pluralité de contacts de détection indépendants correspond à un seul doigt de grille de la pluralité de diodes Schottky. Cela permet d'effectuer des mesures locales et ponctuelles de température. Une cartographie de température au sein du dispositif peut être avantageusement effectuée.

Selon un exemple, les transistors élémentaires sont agencés sous forme de matrice. Selon un exemple, les diodes de type Schottky sont réparties aléatoirement au sein de ladite matrice. Selon un autre exemple, les diodes de type Schottky sont réparties selon une distribution symétrique au sein de ladite matrice. Les diodes Schottky peuvent être réparties en fonction des points chauds du dispositif, par exemple pour éviter une défaillance du dispositif ou pour surveiller une dissipation thermique au sein du dispositif.

Selon un exemple, les transistors élémentaires sont agencés sous forme de matrice rectangulaire, et le dispositif comprend au moins quatre diodes de type Schottky disposées aux quatre coins de ladite matrice rectangulaire. La température mesurée aux coins du dispositif peut être en partie due à des dispositifs adjacents.

Sauf incompatibilité, il est entendu que l'ensemble des caractéristiques optionnelles ci-dessus et/ou les variantes indiquées peuvent être combinées de façon à former un mode de réalisation qui n'est pas nécessairement illustré ou décrit. Un tel mode de réalisation n'est évidemment pas exclu de l'invention.

Dans le cadre de la présente invention, les architectures de dispositifs de puissance envisagées sont basées sur un principe de conduction par gaz bidimensionnel d'électrons (2DEG).

Les transistors de type HEMT (acronyme de « High Electron Mobility Transistor », qui signifie transistor à effet de champ à haute mobilité d'électrons), sont en particulier basés sur cette architecture à gaz bidimensionnel d'électrons. Pour des raisons de tenue en puissance (en particulier à haute tension) et en température, le matériau semiconducteur de ces transistors est de préférence choisi de façon à présenter une large bande d'énergie interdite. Parmi les transistors HEMT à large bande d'énergie interdite, les transistors à base de nitrure de gallium sont généralement préférés.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Par exemple et de façon connue en soi dans le domaine des transistors de type HEMT à base de GaN, une fine couche en AIN peut être intercalée entre deux couches semi-conductrices en GaN et en AlGaN.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants.

Les gammes de dopage associées aux différents types de dopage éventuellement indiqués dans la présente demande sont les suivantes :
- dopage p++ ou n++ : supérieur à 1 x 10²⁰cm⁻³
- dopage p+ ou n+ : 1 x 10¹⁸ cm⁻³ à 9 x 10¹⁹ cm⁻³
- dopage p ou n : 1 x 10¹⁷ cm⁻³ à 1 x 10¹⁸ cm⁻³
- dopage intrinsèque ou non intentionnellement dopé: 1.10¹⁵ cm⁻³ à 1.10¹⁷ cm⁻³

Un repère de préférence orthonormé, comprenant les axes x, y, z est représenté sur les figures annexées.

Dans la présente demande de brevet, la hauteur d'un élément, typiquement un doigt de grille ou de drain, est prise selon z. L'épaisseur d'une couche est prise selon une direction normale au plan d'extension principal de cette couche. Ainsi, une couche peut typiquement présenter une épaisseur selon z. Les termes relatifs « sur », « surmonte », « sous », « sous-jacent », « supérieur », « inférieur » se réfèrent à des positions prises selon la direction z.

Les termes « vertical », « verticalement » se réfèrent à une direction selon z. Les termes « latéral », « latéralement » se réfèrent à une direction dans le plan xy.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Les termes « sensiblement », « environ », « de l'ordre de » signifient « à 10% près » ou, lorsqu'il s'agit d'une orientation angulaire, « à 10° près » et de préférence « à 5° près ». Ainsi, une direction sensiblement normale à un plan signifie une direction présentant un angle de 90±10° par rapport au plan.

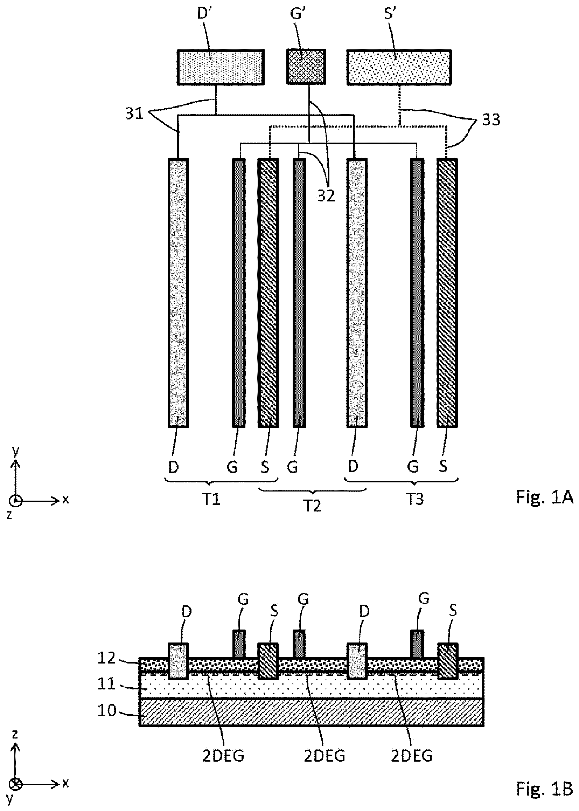

Les figures 1A, 1B illustrent respectivement en vue de dessus et en coupe transverse un dispositif de puissance comprenant plusieurs transistors HEMT élémentaires T1, T2, T3. Cet agencement est connu. Il alterne selon la direction x, de façon classique, un doigt de drain D, un doigt de grille G, un doigt de source S, un doigt de grille G, un doigt de drain D, un doigt de grille G, un doigt de source S.

Les doigts de drain D sont connectés par l'intermédiaire d'une connectique 31 à un contact de drain D'. La connectique 31 comprend de façon classique des vias et des pistes métalliques.

Les doigts de grille G sont connectés par l'intermédiaire d'une connectique 32 à un contact de grille G'. La connectique 32 comprend également de façon classique des vias et des pistes métalliques.

Les doigts de source S sont connectés par l'intermédiaire d'une connectique 33 à un contact de source S'. La connectique 33 comprend également de façon classique des vias et des pistes métalliques.

Les transistors HEMT élémentaires T1, T2, T3 sont typiquement formés sur un substrat comprenant une couche de support 10, par exemple à base de silicium, et une couche active 11 à base de GaN. Cette couche active 11 peut comprendre de façon connue différentes sous-couches à base de GaN et/ou d'AlGaN, par exemple des couches tampon et/ou de germination. Une couche barrière 12, typiquement à base d'AlGaN, permet de former dans la couche active 11 un gaz bidimensionnel d'électrons 2DEG. Ce gaz 2DEG permet la circulation d'un courant entre le doigt de drain D et le doigt de source S d'un transistor élémentaire. La circulation du courant est commandée par une tension Vgs appliquée entre le doigt de grille G et le doigt de source S. Lorsque cette tension est supérieure à la tension de seuil Vth du transistor, le transistor est passant. La caractéristique de tension à l'état passant (dite de premier quadrant) du transistor HEMT présente typiquement un régime linéaire et un régime de saturation. Lorsque la tension Vgs est inférieure à la tension de seuil Vth du transistor, le transistor est bloquant. La caractéristique de tension à l'état bloquant (dite de troisième quadrant) du transistor HEMT ne dépend pas uniquement de la température. Cette caractéristique est également impactée par la polarisation de grille Vgs). Il n'est donc pas possible de déterminer précisément la température du transistor HEMT à partir de la caractéristique de troisième quadrant.

Pour pallier cet inconvénient, une modification structurelle du dispositif est effectuée.

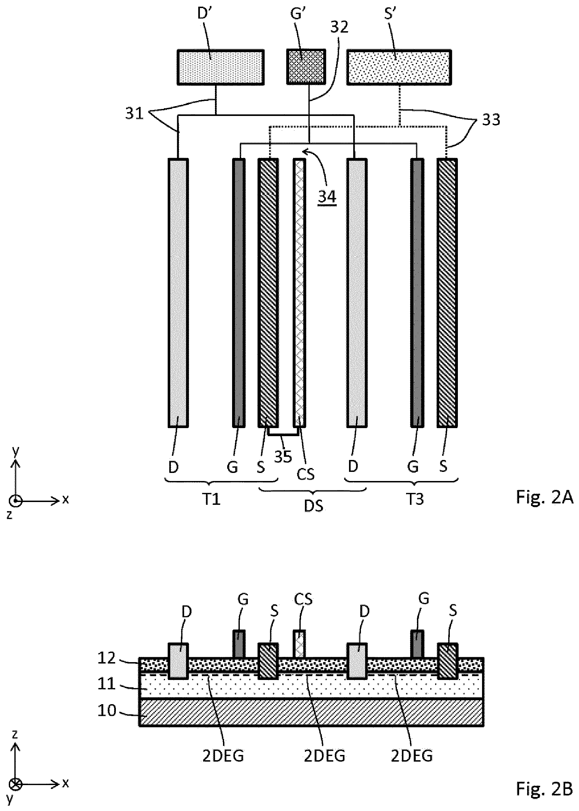

Comme illustré aux figures 2A, 2B, un doigt de grille d'un transistor HEMT élémentaire est modifié de façon à obtenir un contact Schottky CS formant avec le doigt de drain D voisin une diode Schottky DS. Cette modification consiste notamment à déconnecter 34 le doigt de grille du contact de grille G'. La diode Schottky DS est alors formée. Le doigt de grille déconnecté CS correspond à l'anode de la diode Schottky DS. Le doigt de drain D correspond à la cathode de la diode Schottky DS. Cette diode Schottky DS forme avantageusement un capteur de température pour le dispositif. La caractéristique en direct de la diode Schottky DS dépend en effet de la température. La température impacte la pente de la caractéristique de la diode ainsi que sa valeur Vf (tension de seuil Schottky). Pour mesurer la température, un courant constant est d'abord injecté depuis l'anode vers la cathode (sens direct) dans cette diode Schottky DS. La différence de potentiel est ensuite mesurée aux bornes de la diode Schottky DS. En utilisant une table de calibration, par exemple issue des courbes présentées dans le document « UHF IGZO Schottky diode, A. Chasin et al., International Electronic Device Meeting - IEDM 2012 », la température au niveau de la diode DS peut être déterminée à partir de la différence de potentiel mesurée. Par exemple, pour un courant injecté de 0.1 A/mm et une chute de tension mesurée de 0,25V, une température de 378K, soit 105 °C, est déterminée.

Une détermination de la température locale du dispositif est donc possible à partir de la caractéristique I(V) en direct, dans le troisième quadrant, de la diode Schottky DS. Le capteur de température formé par la diode Schottky DS est avantageusement totalement intégré dans le dispositif microélectronique de puissance.

De façon préférée, le doigt de grille déconnecté CS et le doigt de source S sont connectés par une connectique 35. Cela permet d'éviter de former une deuxième diode en sens inverse entre le doigt de grille déconnecté CS et le doigt de source S.

Comme illustré aux figures 2A, 2B, le doigt de grille déconnecté CS peut être structurellement identique aux autres doigts de grille G. Cela minimise les modifications structurelles du dispositif. Le coût de fabrication du capteur de température au sein du dispositif microélectronique de puissance est réduit. Selon une autre possibilité non illustrée, le doigt de grille déconnecté CS peut s'étendre selon z au moins en partie au sein de la couche barrière 12. Cela permet d'ajuster la tension de seuil et la caractéristique de la diode Schottky DS.

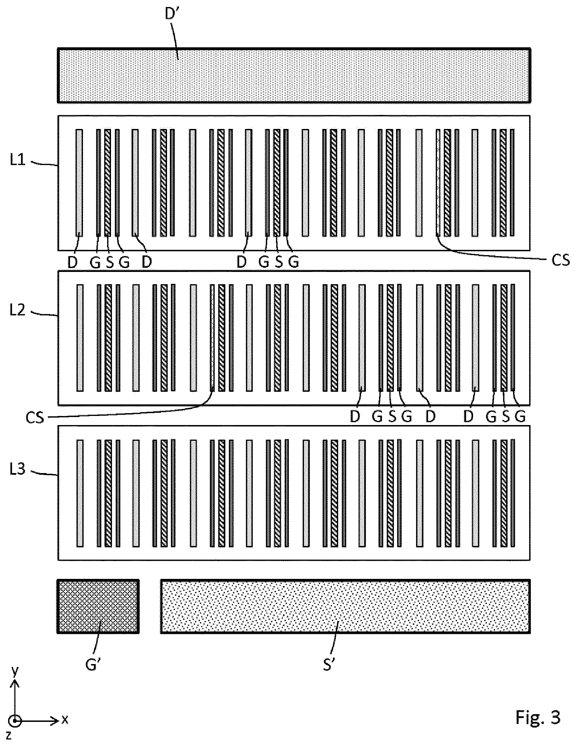

Comme illustré à la figure 3, le dispositif microélectronique de puissance comprend typiquement plusieurs dizaines de transistors HEMT élémentaires agencés en matrice L1, L2, L3. Le contact de drain D' est commun à tous les doigts de drain D. Le contact de source S' est commun à tous les doigts de source S. Le contact de grille G' est commun à tous les doigts de grille G. Il est avantageusement possible de modifier localement quelques doigts de grille de façon à former des contacts Schottky CS. On obtient ainsi plusieurs capteurs de température répartis au sein de la matrice L1, L2, L3 de transistors HEMT élémentaires.

Sur la figure 3, deux contacts Schottky CS parfaitement intégrés au dispositif sont illustrés. Différentes distributions de contacts Schottky CS au sein de la matrice L1, L2, L3 peuvent être envisagées. Selon une possibilité, quatre contacts Schottky CS peuvent être formés aux quatre coins de la matrice L1, L2, L3. Selon une autre possibilité, des contacts Schottky CS peuvent être placés aux points chauds du dispositif. Cela permet de surveiller la température du dispositif en fonctionnement et d'éviter une éventuelle défaillance du dispositif.

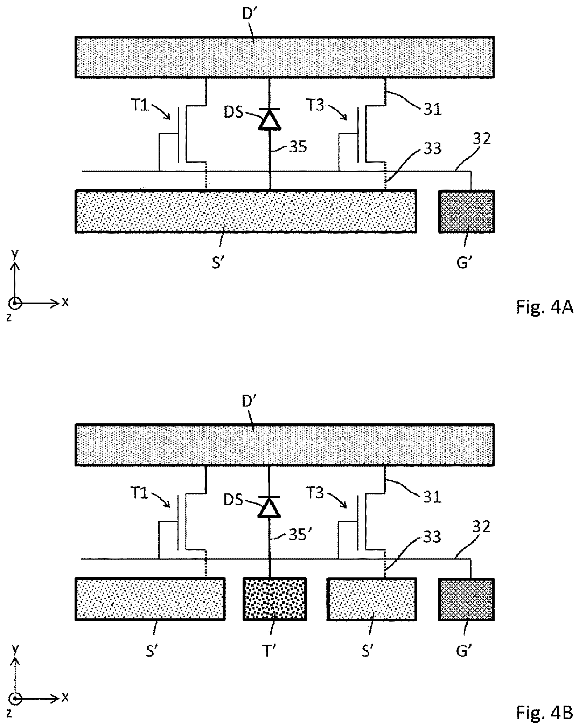

Lorsque l'emplacement des capteurs au sein de la matrice L1, L2, L3 est choisi, différentes configurations de mesure sont envisageables. Les figures 4A, 4B illustrent certaines de ces configurations.

Selon une possibilité illustrée à la figure 4A, les anodes des diodes DS sont reliées au contact de source S', par exemple via la connectique 35 avec le doigt de source voisin du contact Schottky CS. Dans ce cas, la mesure de température est une mesure moyenne sur l'ensemble des capteurs du dispositif. La mesure est ici réalisée en situation de blocage des transistors HEMT élémentaires, dans le troisième quadrant de la caractéristique du dispositif.

Selon une possibilité illustrée à la figure 4B, les anodes des diodes DS sont reliées à un ou plusieurs contacts de détection T'. Les contacts de détection T' sont indépendants des contacts de source S'. Les contacts de détection T' peuvent correspondre à des pads disposés entre les pads de contact S', G', D'. Les contacts de détection T' peuvent être connectés via le doigt de source voisin du contact Schottky CS, par exemple par l'intermédiaire d'une connectique 35' (vias et pistes métalliques) spécifique. Dans ce cas, plusieurs mesures locales de température peuvent être effectuées via les contacts de détection T' reliés aux capteurs du dispositif. Les mesures peuvent être ici réalisées indépendamment du fonctionnement des transistors HEMT élémentaires.

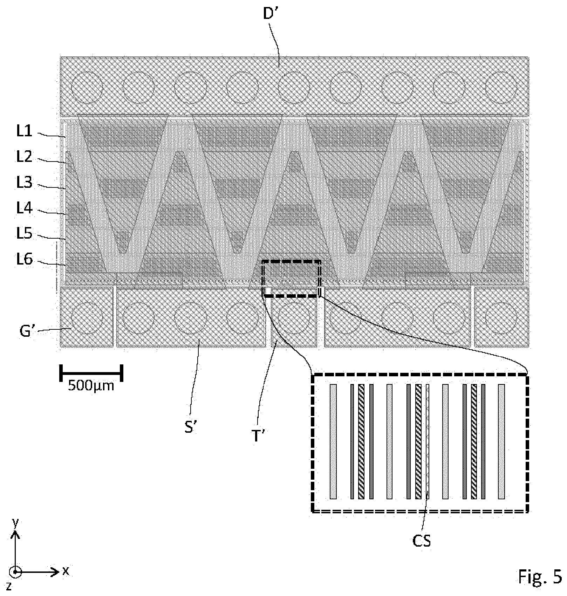

La figure 5 illustre un plan de conception d'un dispositif microélectronique de puissance comprenant six blocs L1, L2, L3, L4, L5, L6 de transistors HEMT élémentaires. Un capteur de température selon l'invention a été implanté dans le bloc L6, et connecté à un pad de contact T' indépendant.

De ce qui précède, il apparaît clairement que la présente invention permet d'intégrer un ou plusieurs capteurs de température précis au sein d'un dispositif microélectronique de puissance comprenant de transistors HEMT élémentaires. L'invention n'est pas limitée aux modes de réalisations précédemment décrits.

## Revendications

1. Dispositif microélectronique de puissance comprenant:
- Une pluralité de transistors (T1, T2, T3) élémentaires à haute mobilité d'électrons formés sur une couche active (11) et connectés en parallèle, chaque transistor (T1, T2, T3) élémentaire comprenant un doigt de source (S), un doigt de drain (D) et un doigt de grille (G) interposé entre le doigt de source (S) et le doigt de drain (D),
- Un contact de source (S') commun aux doigts de source (S),
- Un contact de drain (D') commun aux doigts de drain (D),
- Un contact de grille (G') commun aux doigts de grille (G),
le dispositif étant **caractérisé en ce qu'**au moins un doigt de grille n'est pas connecté au contact de grille (G') et forme un contact Schottky (CS) avec la couche active (11), et **en ce que** ledit au moins un doigt de grille (CS) forme avec le doigt de drain (D) voisin au moins une diode (DS) de type Schottky configurée pour mesurer une température de fonctionnement au sein du dispositif microélectronique de puissance.

2. Dispositif selon la revendication précédente dans lequel l'au moins un doigt de grille (CS) formant le contact Schottky est connecté (35) au doigt de source (S) voisin.

3. Dispositif selon la revendication précédente dans lequel ledit doigt de source (S) voisin est connecté au contact de source (S'), de sorte que la mesure de la température de fonctionnement se fait par l'intermédiaire dudit contact de source (S').

4. Dispositif selon la revendication 2 comprenant au moins un contact de détection (T') indépendant des contacts de source (S'), drain (D') et grille (G'), et dans lequel le doigt de source (S) voisin est connecté audit au moins un contact de détection (T'), de sorte que la mesure de la température de fonctionnement se fait par l'intermédiaire dudit au moins un contact de détection (T').

5. Dispositif selon l'une quelconque des revendications précédentes comprenant en outre une couche barrière (12), par exemple à base d'AlGaN, intercalée entre la couche active (11) et les doigts de grille (G), dans lequel l'au moins un doigt de grille (CS) formant le contact Schottky traverse au moins en partie ladite couche barrière (12).

6. Dispositif selon l'une quelconque des revendications précédentes dans lequel l'au moins un doigt de grille (CS) formant le contact Schottky comprend une pluralité de doigts de grille (CS) formant avec les doigts de drain (D) voisins respectifs une pluralité de diodes (DS) de type Schottky configurées pour mesurer chacune une température de fonctionnement au sein du dispositif microélectronique de puissance.

7. Dispositif selon la revendication précédente comprenant une pluralité de contacts de détection (T') indépendants, dans lequel les doigts de grille (CS) de la pluralité de diodes Schottky (DS) sont connectés auxdits contacts de détection (T') indépendants, de sorte que les températures de fonctionnement sont mesurées par l'intermédiaire desdits contacts de détection (T').

8. Dispositif selon la revendication précédente dans lequel un seul contact de détection (T') de la pluralité de contacts de détection indépendants correspond à un seul doigt de grille (CS) de la pluralité de diodes Schottky (DS).

9. Dispositif selon l'une quelconque des revendications 6 à 8 dans lequel les transistors élémentaires (T1, T2, T3) sont agencés sous forme de matrice (L1, L2, L3, L4, L5, L6) et dans lequel les diodes (DS) de type Schottky sont réparties aléatoirement au sein de ladite matrice.

10. Dispositif selon l'une quelconque des revendications 6 à 8 dans lequel les transistors élémentaires (T1, T2, T3) sont agencés sous forme de matrice rectangulaire, ledit dispositif comprenant au moins quatre diodes (DS) de type Schottky disposées aux quatre coins de ladite matrice rectangulaire.

## Patentansprüche

1. Mikroelektronische Leistungsvorrichtung, die Folgendes umfasst:
- eine Vielzahl von Hoch-Elektronenbeweglichkeits-Basistransistoren (T1, T2, T3), die auf einer aktiven Schicht (11) gebildet und parallel geschaltet sind, wobei jeder Basistransistor (T1, T2, T3) einen Source-Finger (S), einen Drain-Finger (D) und einen Gate-Finger (G) umfasst, der zwischen dem Source-Finger (S) und dem Drain-Finger (D) eingefügt ist,
- einen Source-Kontakt (S'), der den Source-Fingern (S) gemeinsam ist,
- einen Drain-Kontakt (D'), der den Drain-Fingern (D) gemeinsam ist,
- einen Gate-Kontakt (G'), der den Gate-Fingern (G) gemeinsam ist,
Vorrichtung **dadurch gekennzeichnet ist, dass** mindestens ein Gate-Finger nicht mit dem Gate-Kontakt (G') verbunden ist und mit der aktiven Schicht (11) einen Schottky-Kontakt (CS) bildet, und dadurch, dass der mindestens eine Gate-Finger (CS) mit dem benachbarten Drain-Finger (D) mindestens eine Diode vom Schottky-Typ (DS) bildet, die dazu konfiguriert ist, eine Betriebstemperatur innerhalb der mikroelektronischen Leistungsvorrichtung zu messen.

2. Vorrichtung nach dem vorstehenden Anspruch, wobei der mindestens eine Gate-Finger (CS), der den Schottky-Kontakt bildet, mit dem benachbarten Source-Finger (S) verbunden (35) ist.

3. Vorrichtung nach dem vorstehenden Anspruch, wobei der benachbarte Source-Finger (S) mit dem Source-Kontakt (S') derart verbunden ist, dass das Messen der Betriebstemperatur durch den Source-Kontakt (S') erfolgt.

4. Vorrichtung nach Anspruch 2, die mindestens einen Erfassungskontakt (T') umfasst, der von dem Source- (S'), dem Drain- (D') und dem Gate-Kontakt (G') unabhängig ist, und wobei der benachbarte Source-Finger (S) mit dem mindestens einen Erfassungskontakt (T') derart verbunden ist, dass das Messen der Betriebstemperatur durch den mindestens einen Erfassungskontakt (T') erfolgt.

5. Vorrichtung nach einem der vorstehenden Ansprüche, die ferner eine Barriereschicht (12), die beispielsweise auf AlGaN basiert, die zwischen der aktiven Schicht (11) und dem Gate-Finger (G) eingesetzt ist, umfasst, wobei der mindestens eine Gate-Finger (CS), der den Schottky-Kontakt bildet, mindestens teilweise durch die Barriereschicht (12) durchgeht.

6. Vorrichtung nach einem der vorstehenden Ansprüche, wobei der mindestens eine Gate-Finger (CS), der den Schottky-Kontakt bildet, eine Vielzahl von Gate-Fingern (CS) umfasst, die mit den jeweiligen benachbarten Drain-Fingern (D) eine Vielzahl von Dioden vom Schottky-Typ (DS) bildet, die jeweils dazu konfiguriert sind, eine Betriebstemperatur in der mikroelektronischen Leistungsvorrichtung zu bilden.

7. Vorrichtung nach dem vorstehenden Anspruch, die eine Vielzahl unabhängiger Erfassungskontakte (T') umfasst, wobei die Gate-Finger (CS) der Vielzahl von Schottky-Dioden (DS) mit den unabhängigen Erfassungskontakten (T') derart verbunden sind, dass die Betriebstemperaturen durch die Erfassungskontakte (T') gemessen werden.

8. Vorrichtung nach dem vorstehenden Anspruch, wobei ein einziger Erfassungskontakt (T') der Vielzahl unabhängiger Erfassungskontakte einem einzigen Gate-Finger (CS) der Vielzahl von Schottky-Dioden (DS) entspricht.

9. Vorrichtung nach einem der Ansprüche 6 bis 8, wobei die Basistransistoren (T1, T2, T3) in Matrixform (L1, L2, L3, L4, L5, L6) eingerichtet sind, und wobei die Dioden vom Schottky-Typ (DS) willkürlich innerhalb der Matrix verteilt sind.

10. Vorrichtung nach einem der Ansprüche 6 bis 8, wobei die Basistransistoren (T1, T2, T3) in rechteckiger Matrixform eingerichtet sind, wobei die Vorrichtung mindestens vier Dioden vom Schottky-Typ (DS) umfasst, die an den vier Ecken der rechteckigen Matrix angeordnet sind.

## Claims

1. Power microelectronic device comprising:
- A plurality of high electron mobility basic transistors (T1, T2, T3) formed on an active layer (11) and connected in parallel, each basic transistor (T1, T2, T3) comprising a source finger (S), a drain finger (D) and a gate finger (G) interposed between the source finger (S) and the drain finger (D),
- A source contact (S') common to the source fingers (S),
- A drain contact (D') common to the drain fingers (D),
- A gate contact (G') common to the gate fingers (G),
the device being **characterised in that** at least one gate finger is not connected to the gate contact (G') and forms a Schottky contact (CS) with the active layer (11), and **in that** said at least one gate finger (CS) forms, with the neighbouring drain finger (D), at least one Schottky-type diode (DS) configured to measure an operating temperature within the power microelectronic device.

2. Device according to the preceding claim, wherein the at least one gate finger (CS) forming the Schottky contact is connected (35) to the neighbouring source finger (S).

3. Device according to the preceding claim, wherein said neighbouring source finger (S) is connected to the source contact (S'), such that measuring the operating temperature is done through said source contact (S').

4. Device according to claim 2, comprising at least one detection contact (T') independent of the source (S'), drain (D') and gate (G') contacts, and in which the neighbouring source finger (S) is connected to said at least one detection contact (T'), such that measuring the operating temperature is done through said at least one detection contact (T').

5. Device according to any one of the preceding claims, further comprising a barrier layer (12), for example, AlGaN-based, inserted between the active layer (11) and the gate fingers (G), in which the at least one gate finger (CS) forming the Schottky contact passes through at least partially said barrier layer (12).

6. Device according to any one of the preceding claims, wherein the at least one gate finger (CS) forming the Schottky contact comprises a plurality of gate fingers (CS) forming, with the respective neighbouring drain fingers (D), a plurality of Schottky-type diodes (DS) configured to each measure an operating temperature within the power microelectronic device.

7. Device according to the preceding claim, comprising a plurality of independent detection contacts (T'), in which the gate fingers (CS) of the plurality of Schottky diodes (DS) are connected to said independent detection contacts (T'), such that the operating temperatures are measured through said detection contacts (T').

8. Device according to the preceding claim, wherein one single detection contact (T') of the plurality of independent detection contacts corresponds to one single gate finger (CS) of the plurality of Schottky diodes (DS).

9. Device according to any one of claims 6 to 8, wherein the basic transistors (T1, T2, T3) are arranged in matrix form (L1, L2, L3, L4, L5, L6) and in which the Schottky-type diodes (DS) are distributed randomly within said matrix.

10. Device according to any one of claims 6 to 8, wherein the basis transistors (T1, T2, T3) are arranged in rectangular matrix form, said device comprising at least four Schottky-type diodes (DS) disposed at the four corners of said rectangular matrix.
